# EUROPÄISCHE PATENTSCHRIFT

(11) **EP 1 579 038 B1**
(45) Veröffentlichungstag und Bekanntmachung des Hinweises auf die Patenterteilung: **19.10.2016**
(21) Anmeldenummer: 02754447.7
(22) Anmeldetag: 23.07.2002
(51) Int. Cl.: C25D 1/04

(54) **VERFAHREN UND VORRICHTUNG ZUM ERZEUGEN EINES TEXTURIERTEN BANDES AUS METALL**
METHOD AND DEVICE FOR PRODUCING A TEXTURED METAL STRIP
PROCÉDÉ ET DISPOSITIF DESTINÉS À LA PRODUCTION D'UNE BANDE TEXTURÉE DE MÉTAL

(30) Priorität: 25.07.2001 DE 10136890
(43) Veröffentlichungstag der Anmeldung: 28.09.2005
(73) Patentinhaber: Siemens Aktiengesellschaft, 80333 München (DE)
(72) Erfinder: KRUEGER, Ursus, 14098 Berlin (DE); VOGELÄRE, Marc, 13581 Berlin (DE)
(86) Internationale Anmeldenummer: PCT/DE2002/002751
(87) Internationale Veröffentlichungsnummer: WO 2003/012172

(56) Entgegenhaltungen:
- WO-A-03/012166
- DE-A1- 19 942 849
- GB-A- 1 537 243
- US-A- 4 530 739
- R. GOODALL ET AL.: "Fabrication of cube-textured Ag-buffered Ni substrates by electro-epitaxial deposition" SUPERCONDUCTOR SCIENCE AND TECHNOLOGY, Bd. 14, März 2001 (2001-03), Seiten 124-129, XP008042802 in der Anmeldung erwähnt

## Beschreibung

Die Erfindung bezieht sich auf ein Verfahren zum Erzeugen eines biaxial texturierten Bandes aus Metall, bei dem auf einem biaxial texturierten Substrat mit elektrischer Leitfähigkeit eine Metallschicht galvanisch erzeugt wird.

Ein solches Verfahren ist beispielsweise in der Zeitschrift "Supercond. Sci. Technol." 14 (2001), Seiten 124 bis 129 beschrieben. Bei diesem bekannten Verfahren wird ein metallisches, texturiertes Band einseitig mit einer sehr dünnen texturierten Schicht (170 bis 250 nm) versehen, indem diese Schicht elektrolytisch auf dem Band abgeschieden wird. Diese Schicht kann beispielsweise einer Abscheidung eines Supraleiters dienen.

Ein anderes Verfahren zur Herstellung texturierter Bänder ist beispielsweise aus der Zeitschrift "Supercond. Sci. Technol." 12 (1999), Seiten 624 bis 632 bekannt. Bei diesem bekannten Verfahren wird ein Band aus Metall mit einer Textur versehen, indem Walzprozeduren mit Bändern aus Nickel oder Silber bzw. aus Legierungen mit diesen Metallen in Verbindung mit nachfolgenden Glühungen zur Initiierung von Rekristallisierungsprozessen durchgeführt werden. In der Fachwelt werden solche Bänder als RABITS (Rolling assisted biaxial testuring of substrates) bezeichnet. Solche RABITS bilden das Basismaterial zum Herstellen supraleitender Leiter.

Aus der deutschen Offenlegungsschrift DE 199 42 849 A1 ist weiterhin ein Verfahren bekannt, mit dessen Hilfe metallische Bänder auf einem Substrat in hinreichender Dicke erzeugt werden können, um anschließend von dem Substrat getrennt werden zu können. Aus der US 4,530,739 ist es außerdem bekannt, dass ein walzenförmiges Substrat mit einer dreidimensionalen Oberflächenstrukturierung versehen werden kann, damit diese auf das abgeschiedene Material abgebildet wird. Dieses kann anschließend von der Walze abgezogen werden, wobei die Oberflächenstrukturierung erhalten bleibt. Aus der GB 1 537 243 ist es auch bekannt, dass das walzenförmige Substrat Bereiche der Oberfläche beinhalten kann, die elektrisch nicht leitend ausgeführt sind. In diesen Bereichen lässt sich dann kein Material abscheiden, so dass das ausgebildete Band Löcher oder andere Aussparungen aufweist.

Der Erfindung liegt die Aufgabe zugrunde, ein Verfahren zum Erzeugen eines biaxial texturierten und mit YBa₂Cu₃O₇ beschichteten Bandes anzugeben, das sich vergleichsweise kostengünstig durchführen lässt.

Zur Lösung dieser Aufgabe wird erfindungsgemäß die Metallschicht unter Gewinnung des biaxial texturierten Bandes von dem Substrat gelöst.

Der wesentliche Vorteil des erfindungsgemäßen Verfahrens besteht darin, dass nach Herstellung eines texturierten Substrats mit elektrischer Leitfähigkeit mit der so gewonnenen "Matrize" durch jeweils einen einfachen Galvanikprozess und anschließendes Lösen der Metallschicht von der Matrize bzw. von dem texturierten Substrat ein texturiertes Band aus Metall erzeugt werden kann, das zum Aufbringen einer Schicht aus einem supraleitendem Werkstoff zur Bildung eines Supraleiters sehr gut geeignet ist.

Bei dem erfindungsgemäßen Verfahren können unterschiedlich bezüglich der Gewährleistung der elektrischen Leitfähigkeit ausgeführte Substrate eingesetzt werden. So wird es als vorteilhaft angesehen, wenn ein Substrat aus elektrisch nichtleitendem Material mit einer elektrisch leitenden Oberfläche verwendet wird, weil auf diese Weise auch beispielsweise Kunststoffe zur Erzeugung des Substrates herangezogen werden können.

Es kann aber auch vorteilhaft sein, dass ein Substrat aus einem Metall verwendet wird, weil dann zum Gewinnen des Substrates nur mit einem einzigen Werkstoff umgegangen werden muss.

Das texturierte Substrat kann unterschiedliche geometrische Abmessungen aufweisen, z. B. eine Platte sein. Als besonders vorteilhaft wird es erachtet, wenn als texturiertes Substrat ein Substratband verwendet wird, weil dies der Herstellung eines texturierten Bandes aus Metall besonders entgegenkommt.

Bei dem erfindungsgemäßen Verfahren können verschiedene texturierte Substratbänder verwendet werden. So wird es als vorteilhaft angesehen, wenn als Substratband ein nichttexturiertes Metallband mit aufgebrachter biaxial texturierter Metalllage verwendet wird.

Ferner kann es vorteilhaft sein, wenn als Substratband ein durch Walzprozeduren mit nachfolgenden Glühungen texturiertes Metallband verwendet wird, also nach dem RABITS-Verfahren erzeugte Metallsubstrate zur Anwendung gelangen.

Bei dem erfindungsgemäßen Verfahren können Metallschichten aus unterschiedlichen Metallen auf dem Substrat erzeugt werden. Vorteilhaft kann das Aufbringen einer Metallschicht aus Nickel oder einer Nickellegierung sein. Besonders vorteilhaft erscheint es jedoch, wenn eine Metallschicht aus Silber oder Kupfer oder aus einer Silberlegierung oder Kupferlegierung aufgebracht wird, weil bei einem späteren Einsatz in einem magnetischen Wechselfeld - anders als bei Nickel - durch Verluste aufgrund von Paramagnetismus keine störenden Einflüsse auftreten.

Bei dem erfindungsgemäßen Verfahren kann als Substrat ein gestrecktes Band mit bestimmter Länge verwendet werden, das durch eine Galvanisiereinrichtung zum Bilden der Metallschicht gezogen wird und von dem anschließend die Metallschicht als texturiertes Band abgezogen wird. Als besonders vorteilhaft wird es aber angesehen, wenn als Substratband ein Substrat-Endlosband verwendet wird, das durch ein Galvanikbad unter Bildung der Metallschicht geführt und von dem anschließend die Metallschicht abgezogen wird, weil auf diese Weise ein nahezu beliebig langes texturiertes Band aus Metall gewonnen werden kann.

Das Substrat-Endlosband kann unterschiedlich eingesetzt werden. Vorteilhaft erscheint es, wenn das Substrat-Endlosband über Rollen durch das Galvanikbad geführt wird. Bei einer anderen vorteilhaften Ausführungsform des erfindungsgemäßen Verfahrens wird das Substratband außen auf eine Walze aufgebracht und die Walze unter Eintauchen in ein Galvanikbad in Drehbewegung versetzt.

Bei einer besonders vorteilhaften Variante des erfindungsgemäßen Verfahrens wird ein texturiertes Substrat verwendet, das nichtleitende Bereiche aufweist. Der wesentliche Vorteil dieser Ausführungsform liegt darin, dass beim galvanischen Erzeugen der Metallschicht in nichtleitenden Bereichen keine Metallschicht, so dass - im Falle einer später aufzubringenden Schicht aus einem supraleitenden Werkstoff zur Bildung eines Supraleiters - die Topologie für den Supraleiter bereits vorgegeben ist, ohne dass dazu weitere Schritte durchgeführt werden.

Die Erfindung bezieht sich weiterhin auf eine Vorrichtung zum Erzeugen eines Bandes aus Metall, bei der eine Antriebseinrichtung für ein Substrat-Endlosband einem Galvanikbad derart zugeordnet ist, dass das Substrat-Endlosband durch das Galvanikbad unter Bildung einer Metallschicht auf dem Substrat-Endlosband läuft und der Antriebseinrichtung benachbart eine Vorrichtung zum Abziehen der Metallschicht von dem Substrat-Endlosband liegt.

Die zum Verfahren gehörige Vorrichtung hat den Vorteil, dass sich mit wenig Aufwand ein texturiertes Band aus Metall mit nahezu beliebiger Länge herstellen lässt.
Bei der erfindungsgemäßen Vorrichtung kann die Antriebseinrichtung unterschiedlich ausgebildet sein. Wird eine gestreckte Antriebseinrichtung bevorzugt, dann weist erfindungsgemäß die Antriebseinrichtung mindestens zwei Rollen auf, um die das Substrat-Endlosband geführt und mit denen es angetrieben wird. Eine mehr kompakte Antriebsvorrichtung ist erzielbar, wenn die Antriebseinrichtung eine angetriebene Walze aufweist, die an ihrem Umfange außen das Substrat-Endlosband trägt.

Als zur Erfindung gehörend wird ferner die Verwendung des mittels eines texturierten Substrates galvanisch hergestellten Bandes aus Metall, wie z. B. Silber oder einer Silberlegierung, als Träger für eine Schicht aus einem supraleitenden Material zur Bildung eines supraleitenden Leiters angesehen. Ein solcher supraleitender Leiter verursacht bei einem Band aus Silber oder Kupfer keine störenden Einflüsse bei einem Einsatz in magnetischen Wechselfeldern.

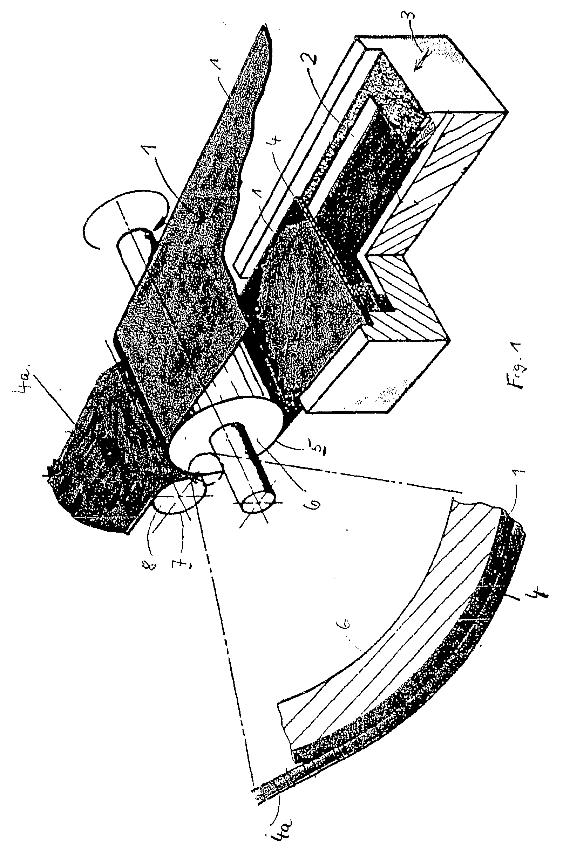

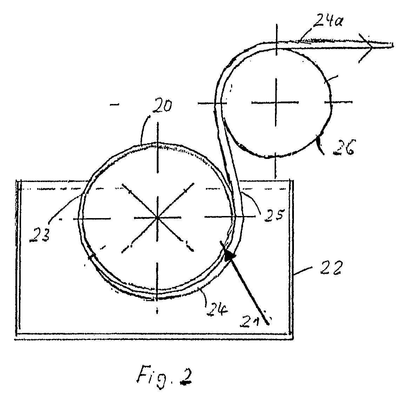

Zur Erläuterung des erfindungsgemäßen Verfahrens ist in Figur 1 ein Ausführungsbeispiel einer Vorrichtung zum Herstellen eines texturierten Bandes aus Metall und in Figur 2 ein weiteres Ausführungsbeispiel für eine solche Vorrichtung wiedergegeben.

Zur Durchführung des erfindungsgemäßen Verfahrens ist ein texturiertes Substrat beispielsweise aus Metall erforderlich, das beispielsweise nach dem RABITS-Verfahren hergestellt sein kann.

Die Figur 1 zeigt ein texturiertes Substrat in Form eines Substrat-Endlosbandes 1 auf das beim Durchlaufen durch ein Galvanikbad 2 in Richtung des Pfeiles 3 galvanisch eine texturierte Metallschicht 4 allmählich aufwächst. Das Substrat-Endlosband 1 wird von einer Antriebseinrichtung 5 mit Umlenkrollen angetrieben, von der in der Figur 1 nur eine einzige Umlenkrolle 6 zu sehen ist.

Der Antriebseinrichtung 5 benachbart ist eine Vorrichtung 7 zum Abziehen der Metallschicht 4 von dem texturierten Substrat-Endlosband 1 angeordnet; die Vorrichtung 7 weist eine Abziehrolle 8, der eine nicht weiter dargestellte Zugvorrichtung für die Metallschicht 4 nachgeordnet ist, auf. Die Metallschicht 4 bildet ein texturiertes Band 4a aus Metall, das mit der dargestellten Vorrichtung fast beliebig lang ausgeführt werden kann.

Die vergrößerte Teildarstellung der Figur 1 zeigt den Trennvorgang der Metallschicht 4a bzw. des texturierten Bandes 4 von dem texturierten Substrat.

Dieses texturierte Band 4a ist dann gut als Träger für eine Schicht aus einem supraleitenden Material, z. B. YBa₂Cu₃ 0₇, geeignet, wenn ein supraleitender Leiter erzeugt werden soll.

Bei dem Ausführungsbeispiel nach Figur 2 ist ein texturiertes Substrat-Endlosband 20 auf einer Walze 21 aufgebracht. Die Walze 21 ist drehbar in einem nur schematisch dargestellten Galvanikbad 22 angeordnet. Bei der Drehbewegung der Walze 21 beginnt jeweils vom Eintauchbereich 23 der Walze 21 in das Galvanikbad 22 eine texturierte Metallschicht 24 aufzuwachsen, die ihre größte Stärke im Auftauchbereich 25 erreicht. Dort wird die Metallschicht 24 als texturiertes Band 24a aus Metall von der Walze 21 mittels einer Abziehrolle 26 als Vorrichtung zum Abziehen abgezogen.

## Patentansprüche

1. Verfahren zum Erzeugen eines biaxial texturierten Bandes aus Metall mit einer Schicht aus dem Supraleiter YBa₂Cu₃O₇, bei dem
- auf einem biaxial texturierten Substrat (1) mit elektrischer Leitfähigkeit eine für die Abscheidung des Supraleiters YBa₂Cu₃O₇ geeignete biaxial texturierte Metallschicht (4) aus Nickel, einer Nickellegierung, Kupfer, einer Kupferlegierung, Silber oder einer Silberlegierung galvanisch erzeugt wird, wobei
- die Metallschicht (4) unter Gewinnung des biaxial texturierten Bandes (4a) von dem Substrat (1) gelöst wird und
- auf dem biaxail texturierten Band eine Schicht aus dem Supraleiter YBa₂Cu₃O₇ abgeschieden wird.

2. Verfahren nach Anspruch 1,
**dadurch gekennzeichnet, dass**
- ein Substrat (1) aus elektrisch nichtleitendem Material mit einer elektrisch leitenden Oberfläche verwendet wird.

3. Verfahren nach Anspruch 1,
**dadurch gekennzeichnet, dass**
- ein Substrat (1) aus einem Metall verwendet wird.

4. Verfahren nach einem der Ansprüche 1 bis 3,
**dadurch gekennzeichnet, dass**
- als biaxial texturiertes Substrat ein Substratband (1) verwendet wird.

5. Verfahren nach Anspruch 4,
**dadurch gekennzeichnet, dass**
- als Substratband (1) ein nichttexturiertes Metallband mit aufgebrachter biaxial texturierter Metalllage verwendet wird.

6. Verfahren nach Anspruch 4,
**dadurch gekennzeichnet, dass**
- als Substratband (1) ein durch Walzprozeduren mit nachfolgenden Glühungen biaxial texturiertes Metallband verwendet wird.

7. Verfahren nach einem der Ansprüche 4 bis 6,
**dadurch gekennzeichnet, dass**
- als Substratband ein Substrat-Endlosband (1) verwendet wird, das durch ein Galvanikbad unter Bildung der Metallschicht (4) geführt wird und von dem anschließend die Metallschicht (4) von dem Substrat-Endlosband (1) abgezogen wird.

8. Verfahren nach Anspruch 7,
**dadurch gekennzeichnet, dass**
- das Substrat-Endlosband (1) über Rollen (6) durch das Galvanikbad geführt wird.

9. Verfahren nach Anspruch 7,
**dadurch gekennzeichnet, dass**
- das Substratband (20) außen auf eine Walze (21) aufgebracht wird und,
- die Walze (21) unter Eintauchen in ein Galvanikbad (22) in Drehbewegung versetzt wird.

10. Verfahren nach einem der vorangehenden Ansprüche,
**dadurch gekennzeichnet, dass**
- ein biaxial texturiertes Substrat verwendet wird, das texturfreie Bereiche aufweist.

## Claims

1. Process for producing a biaxially textured strip from metal having a layer made from the super conductor YBa₂Cu₃O₇, in which
- a biaxially textured metal layer (4) of nickel, a nickel alloy, copper, a copper alloy, silver or a silver alloy which is suitable for the deposition of the superconductor YBa₂Cu₃O₇ is produced by electroplating on a biaxially textured substrate (1) with an electrical conductivity, wherein
- the metal layer (4) is removed from the substrate (1) so as to obtain the biaxially textured strip (4a) and
- a layer made from the superconductor YBa₂Cu₃O₇ is deposited on the biaxially textured strip.

2. Process according to Claim 1, **characterized in that**
- a substrate (1) made from electrically nonconductive material with an electrically conductive surface is used.

3. Process according to Claim 1, **characterized in that**
- a substrate (1) made from a metal is used.

4. Process according to one of Claims 1 to 3, **characterized in that**
- a substrate strip (1) is used as the biaxially textured substrate.

5. Process according to Claim 4, **characterized in that**
- a non-textured metal strip with an applied biaxially textured metal layer is used as the substrate strip (1).

6. Process according to Claim 4, **characterized in that**
- a metal strip which has been biaxially textured by rolling procedures followed by annealing steps is used as the substrate strip (1).

7. Process according to one of Claims 4 to 6, **characterized in that**
- the substrate strip used is an endless substrate strip (1) which is passed through an electroplating bath so as to form the metal layer (4) and from which the metal layer (4) is subsequently pulled off from the endless substrate strip (1).

8. Process according to Claim 7, **characterized in that**
- the endless substrate strip (1) is passed through the electroplating bath over rolls (6).

9. Process according to Claim 7, **characterized in that**
- the substrate strip (20) is applied to the outside of a roller (21), and
- the roller (21) is set in rotary motion, with immersion in an electroplating bath (22).

10. Process according to one of the preceding claims, **characterized in that**
- a biaxially textured substrate which has texture-free regions is used.

## Revendications

1. Procédé de production d'un feuillard texturé biaxialement en métal ayant une couche en le supraconducteur YBa₂Cu₃O₇, dans lequel
- on produit galvaniquement, sur un substrat (1) texturé biaxialement et ayant de la conductivité électrique, une couche (4) métallique en nickel, en un alliage de nickel, en cuivre, en un alliage de cuivre, en argent ou en un alliage d'argent, texturé biaxialement propre au dépôt du supraconducteur YBa₂Cu₃O₇, dans lequel
- on sépare du substrat (1) la couche (4) métallique en obtenant le feuillard (4a) texturé biaxialement, et
- on dépose une couche en le supraconducteur YBa₂Cu₃O₇ sur le feuillard texturé biaxialement.

2. Procédé suivant la revendication 1,
**caractérisé en ce que**
- on utilise un substrat (1) en un matériau non-conducteur de l'électricité ayant une surface conductrice de l'électricité.

3. Procédé suivant la revendication 1,
**caractérisé en ce que**
- on utilise un substrat (1) en un métal.

4. Procédé suivant l'une des revendications 1 à 3,
**caractérisé en ce que**
- on utilise un feuillard (1) de substrat comme substrat texturé biaxialement.

5. Procédé suivant la revendication 4,
**caractérisé en ce que**
- on utilise comme feuillard (1) de substrat un feuillard métallique non texturé ayant une couche métallique texturée biaxialement qui y est déposée.

6. Procédé suivant la revendication 4,
**caractérisé en ce que**
- on utilise comme feuillard (1) de substrat un feuillard métallique texturé biaxialement par des procédures de laminage suivies de recuits.

7. Procédé suivant l'une des revendications 4 à 6,
**caractérisé en ce que**
- on utilise comme feuillard de substrat un feuillard (1) de substrat sans fin que l'on fait passer dans un bain galvanique avec formation de la couche (4) de métal et duquel on retire ensuite la couche (4) de métal de la bande (1) sans fin de substrat.

8. Procédé suivant la revendication 7,
**caractérisé en ce que**
- on fait passer la bande (1) sans fin de substrat dans le bain galvanique par l'intermédiaire de rouleaux (6).

9. Procédé suivant la revendication 7,
**caractérisé en ce que**
- on dépose le feuillard (20) de substrat de l'extérieur sur un cylindre (21), et
- on met en rotation le cylindre (21) tout en le plongeant dans un bain (22) galvanique.

10. Procédé suivant l'une des revendications précédentes,
**caractérisé en ce que**
- on utilise un substrat texturé biaxialement qui a des parties sans texturation.
